# EUROPEAN PATENT SPECIFICATION

(11) **EP 3 149 329 B1**
(45) Date of publication and mention of the grant of the patent: **29.01.2020**
(21) Application number: 15732082.1
(22) Date of filing: 28.05.2015
(51) Int. Cl.: F04B 9/02, F04B 19/04, F04B 23/04, F04B 43/02, F04B 49/10, F04B 49/22, F04B 51/00, F04B 53/10, F04B 53/16, H01L 21/67, F04B 17/03, F04B 43/04, F04B 13/00, F16H 25/20, F04B 53/20

(54) **ANTI-BACKLASH MECHANISM FOR MOTOR-DRIVEN COMPONENTS IN PRECISION SYSTEMS AND APPLICATIONS**
VORRICHTUNG ZUR VERHINDERUNG VON MECHANISCHEM SPIEL BEI MOTORGETRIEBENEN KOMPONENTEN IN PRÄZISIONSSYSTEMEN UND VERWENDUNGEN
MÉCANISME ANTI-JEU POUR DES COMPOSANTES ENTAINÉES PAR UN MOTEUR DANS DES SYSTÈMES ET DES UTILISATIONS À PRÉCISION

(30) Priority: 28.05.2014 US 201462004117 P
(43) Date of publication of application: 05.04.2017
(73) Proprietor: Entegris, Inc., Billerica, MA 01821-4600 (US)
(72) Inventor: CEDRONE, James, Braintree, MA 02184 (US); GASHGAEE, Iraj, Marlborough, MA 01752 (US); GONNELLA, George,L., Pepperell, MA 01463-0412 (US)
(74) Representative: Greaves Brewster LLP
(86) International application number: PCT/US2015/032816
(87) International publication number: WO 2015/184056

(56) References cited:
- US-A- 4 896 552
- US-A- 4 954 032
- US-A1- 2004 250 637
- US-A1- 2007 104 586

## Description

### CROSS-REFERENCE TO RELATED APPLICATION(S)

This application claims a benefit of priority from U.S. Provisional Application No. 62/004,117, filed May 28, 2014.

### TECHNICAL FIELD

This disclosure relates generally to anti-backlash mechanisms and, more particularly, to an anti-backlash mechanism for motor-driven components such as pistons or valves used in semiconductor manufacturing and other precision applications.

### BACKGROUND

In a mechanical system, clearance or gaps between parts may cause one part to be moved in one direction without applying appreciable force or motion to the next part in a mechanical sequence. This is referred to as backlash and is a known characteristic of mechanical systems.

Backlash may allow for lubrication, manufacturing errors, deflection under load, thermal expansion, etc. In practice, many applications allow some backlash to prevent jamming.

For some applications, however, backlash may not be desirable. Indeed, minimal or zero backlash may be desired for precision applications.

For example, single- and multi-stage pumps used in semiconductor manufacturing processes need to provide precise control over the amount and/or rate at which a fluid is dispensed, for instance, onto a wafer. However, motor-driven piston assemblies in these pumps may suffer backlash, which can reduce their accuracy. As another example, backlash could be an issue for sensing and control applications where a valve is driven by a motor to open and close. As yet another example, liquid flow control systems employing motor-driven valves may suffer backlash.

Current anti-backlash solutions can be quite limited or even non-existent for certain applications that are constrained by various factors such as manufacturing tolerance, fluid flow direction, available space for adding an anti-backlash device, additional load that might be placed on a motor due to the addition of an anti-backlash device, the motor size, additional heat that might be generated by the motor, etc. For example, one anti-backlash solution may involve increasing the power of a motor to eliminate the backlash. However, in providing more power the motor also generates more heat. In applications where a temperature-sensitive fluid is used, this anti-backlash solution would not be feasible or desirable as the higher temperature may damage the fluid. Furthermore, in cases where the size of the motor needs to be increased to provide more power, this anti-backlash solution would not be feasible or desirable for systems where space is limited or constrained.

Document US4954032 discloses an anti-backlash nut having a pair of nut segments, each with an internal threaded bore adapted to receive a threaded bolt, one having a portion insertable within the other nut segment. Interlocking means are provided to lock the two nut segments together and permits movement of said two nut segments away from each other to keep the threads of the bores of the two in contact with the threads of the bolt.

Document 2007/104586 discloses a system and method for compensating for pressure increase which may occur in various enclosed spaces of a pumping apparatus, particularly in chambers of a pumping apparatus by moving a pumping means to adjust the volume of the chamber to compensate for a pressure increase in the chamber.

In view of the foregoing, there is a continuing need for an anti-backlash solution useful for precision systems, for instance, semiconductor manufacturing process fluid delivery, dispense, and flow control systems. Embodiments disclosed herein can address this need and more.

### SUMMARY

A solution according to the present invention is provided by a piston assembly comprising an anti-backlash device having the technical features defined by the subject-matter of patent claim 1. An anti-backlash device according to embodiments disclosed may include a first nut having a first engagement feature and a first rotation locking feature. The first engagement feature can be one of many engagement features, including inner threads and balls (in a ball screw arrangement). The first engagement feature of the first nut is structured for engagement with a lead screw of a motor. The first nut is coupled to a piston driven by the motor and is fixed in relation to the piston.

The anti-backlash device may further include a second nut having a second engagement feature and a second rotation locking feature. Like the first engagement feature, the second engagement feature can be one of many engagement features, including inner threads and balls. the second engagement feature of the second nut is also structured for engagement with the lead screw. The second rotation locking feature of the second nut and the first rotation locking feature of the first nut can be complementary such that they can be coupled or interlocked to limit or prevent relative rotation between the first nut and the second nut.

The anti-backlash device may further include a spring force biasing member for maintaining a spaced relationship between the first nut and the second nut along the lead screw such that the first engagement feature of the first nut remains in engagement with the lead screw to thereby reduce or eliminate backlash when the lead screw is rotated by the motor in a first direction. The second engagement feature of the second nut may remain in engagement with the lead screw to thereby reduce or eliminate backlash when the lead screw is rotated by the motor in a second direction.

The anti-backlash device is part of a piston assembly. The piston may have a diaphragm and a cavity for housing all or a substantial portion of the anti-backlash device. The piston may include an opening at an end distal from the diaphragm for receiving the first nut and side opening for receiving set screws to prevent counter rotation or to prevent the first nut from backing out. The piston assembly may include an anti-rotation mechanism to prevent rotation of the anti-backlash mechanism relative to the piston.

The piston assembly may be part of a dispense pump which, in turn, may be part of a pumping system. The piston assembly further comprises an anti-rotation mechanism to prevent rotation of the anti-backlash mechanism relative to the piston. The anti-backlash device may be spaced along the lead screw a distance away from the motor. Specifically, the first nut, the second nut, and the biasing member are axially aligned along and pass through the lead screw. The first nut may be located more proximate to the motor than the second nut.

Numerous other embodiments may also be possible as long as they fall under the scope of protection defined by the subject-matter of the appended patent claims.

These, and other, aspects of the invention will be better appreciated and understood when considered in conjunction with the following description and the accompanying drawings. The following description, while indicating various embodiments of the invention and numerous specific details thereof, is given by way of illustration and not of limitation. Many substitutions, modifications, additions or rearrangements may be made within the scope of protection defined by the subject-matter of the appended patent claims.

### BRIEF DESCRIPTION OF THE DRAWINGS

The drawings accompanying and forming part of this specification are included to depict certain aspects of the invention. A clearer impression of the invention, and of the components and operation of systems provided with the invention, will become more readily apparent by referring to the exemplary, and therefore non-limiting, embodiments illustrated in the drawings, wherein identical reference numerals designate the same components. Note that the features illustrated in the drawings are not necessarily drawn to scale.
FIGURE 1 depicts a diagrammatic representation of an exemplary pumping system.
FIGURE 2 depicts a diagrammatic representation of an exemplary multiple stage pump ("multi-stage pump").
FIGURES 3A and 3B depict valve and motor timing diagrams for an exemplary multi-stage pump.
FIGURES 4A and 4B are plot diagrams illustrating an example of a backlash event and elimination of the backlash event by manipulation of ready pressure.
FIGURE 5A depicts an exploded perspective view of an exemplary motor-driven piston assembly with one embodiment of an anti-backlash mechanism installed on a piston.
FIGURE 5B depicts a cross-sectional view of an exemplary motor-driven piston assembly with one embodiment of an anti-backlash mechanism installed on a piston.
FIGURES 6A and 6B are plot diagrams exemplifying how an anti-backlash mechanism disclosed herein can eliminate backlash regardless of ready pressure settings.

### DETAILED DESCRIPTION

Systems and methods and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure the invention in detail. It should be understood, however, that the detailed description and the specific examples, while indicating preferred embodiments of the invention, are given by way of illustration only and not by way of limitation. The scope of protection of the invention is defined by the subject-matter of the appended patent claims.

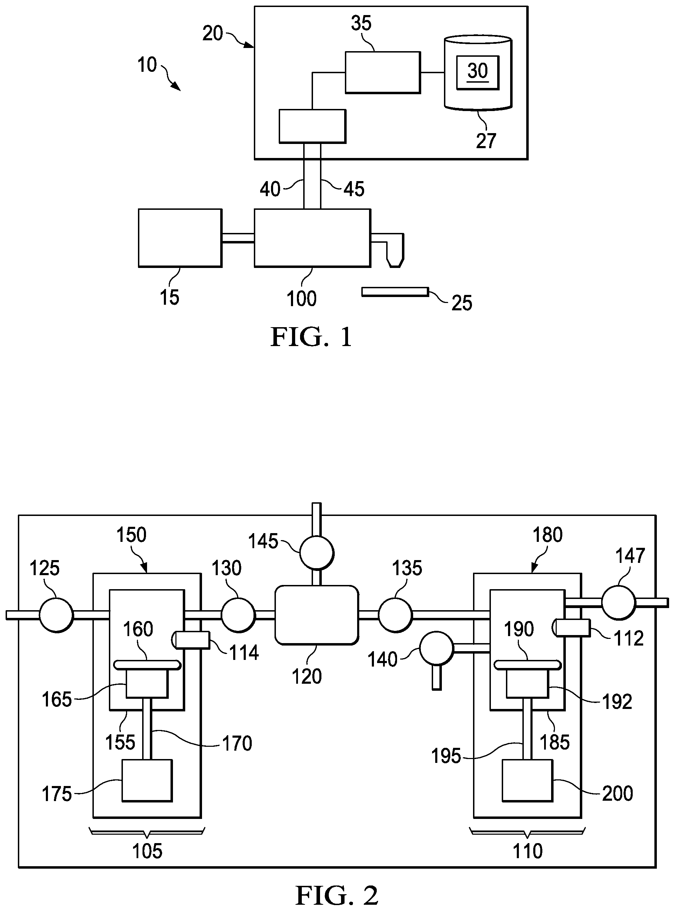

Before describing embodiments, it may be useful to describe an exemplary pump or pumping system which may be utilized with various embodiments. FIGURE 1 depicts a diagrammatic representation of a pumping system 10. Pumping system 10 can include a fluid source 15, a pump controller 20 and a multi-stage pump 100, which work together to dispense fluid onto a wafer 25. Fluid source 15 can be any appropriate source such as a tank, a bottle, a fluid processing system, or a fluid carrying network from which multi-stage pump 100 obtains a process fluid, for instance, a semiconductor manufacturing process fluid. Semiconductor manufacturing processes are known to those skilled in the art and thus are not described herein.

Operation of multi-stage pump 100 can be controlled by pump controller 20, which can be onboard multi-stage pump 100 or connected to multi-stage pump 100 via one or more communications links for communicating control signals, data or other information. Pump controller 20 can include a variety of computer components known in the art, including processors, memories, interfaces, display devices, peripherals, or other computer components. For example, pump controller 20 can include a processor 35 implementing a Central Processing Unit (CPU), Application Specific Integrated Circuit (ASIC), Digital Signal Processing (DSP), Reduced Instruction Set Computing (RISC) or other processor. One example of a suitable processor is the Texas Instruments TMS320F28335PGFA 16-bit DSP (Texas Instruments is a Dallas, TX based company). Additionally, pump controller 20 can include at least one computer readable medium 27 (e.g., random access memory (RAM), read-only memory (ROM), flash memory, optical disk, magnetic drive or other computer readable medium).

In the example of FIGURE 1, pump controller 20 communicates with multi-stage pump 100 via communications links 40 and 45. Communications links 40 and 45 can be networks (e.g., Ethernet, EtherCAT, wireless network, global area network, DeviceNet network or other network known or developed in the art), a bus (e.g., Small Computer System Interface (SCSI) bus) or other communications links. These communications components are known to those skilled in the art.

Pump controller 20 can be implemented as an onboard printed circuit board (PCB), remote controller, or in other suitable manner. Pump controller 20 can include appropriate interfaces (e.g., EtherCAT, network interfaces, input/output (I/O) interfaces, analog to digital converters and other components) to allow pump controller 20 to communicate with multi-stage pump 100, pump tracks, management stations, etc.

A pump track refers to a tool or system with necessary hardware and software to perform an operation (e.g., a chemical deposition or fluid coating process) on a wafer surface. In doing so, a precise volume of fluid needs to be applied to the surface of wafer 25. Pump controller 20 can control various valves and motors in multi-stage pump 100 to cause multi-stage pump 100 to accurately dispense various types of fluids, including low viscosity fluids (i.e., less than 5 centipoise). The control logic for controlling the operation of multi-stage pump 100 may be embodied on pump controller 20, a management station, and/or other computing device. In pump controller 20, control instructions 30 may be embodied on non-transitory computer readable medium 27. Examples of control schemes can be found in U.S. Patent No. 8,029,247, entitled "SYSTEM AND METHOD FOR PRESSURE COMPENSATION IN A PUMP"; U.S. Patent No. 7,443,483, entitled "SYSTEMS AND METHODS FOR FLUID FLOW CONTROL IN AN IMMERSION LITHOGRAPHY SYSTEM"; U.S. Patent No. 8,172,546, entitled "SYSTEM AND METHOD FOR CORRECTING FOR PRESSURE VARIATIONS USING A MOTOR"; U.S. Patent No. 7,850,431, entitled "SYSTEM AND METHOD FOR CONTROL OF FLUID PRESSURE"; U.S. Patent No. 7,878,765, entitled "SYSTEM AND METHOD FOR MONITORING OPERATION OF A PUMP"; and U.S. Patent No. 7,940,664, entitled "I/O SYSTEMS, METHODS AND DEVICES FOR INTERFACING A PUMP CONTROLLER".

FIGURE 2 depicts a diagrammatic representation of multi-stage pump 100. In this example, multi-stage pump 100 includes a feed stage portion 105 and a separate dispense stage portion 110. Located between feed stage portion 105 and dispense stage portion 110, from a fluid flow perspective, is filter 120 to filter out or otherwise remove impurities from a process fluid.

Feed stage portion 105 and dispense stage portion 110 can include pumps 150, 180 for directing the process fluid to flow from a fluid source (e.g., fluid source 15 shown in FIGURE 1) to feed stage 105 to filter 120 to dispense stage 110 to a point of dispense or use. To control the fluid flow, multi-stage pump 100 includes a number of valves including, for example, inlet valve 125, isolation valve 130, barrier valve 135, purge valve 140, vent valve 145 and outlet valve 147. These valves are opened or closed to allow or restrict fluid flow to various portions of multi-stage pump 100. For example, these valves can be pneumatically actuated (i.e., gas driven) diaphragm valves that open or close depending on whether pressure or a vacuum is asserted. However, any suitable valve can be used.

In the example of FIGURE 2, feed-stage pump 150 ("feed pump 150") includes a feed chamber 155 to collect fluid, a feed stage diaphragm 160 to move within feed chamber 155 and displace fluid, a piston 165 to move feed stage diaphragm 160, a lead screw 170 connected to piston 165, and a feed motor 175 (e.g., a stepper motor) to drive lead screw 170 and hence piston 165. As an example, lead screw 170 can be coupled to motor 175 through a nut, gear or other mechanism for imparting energy from motor 175 to lead screw 170. Specifically, motor 175 is operable to rotate the nut that, in turn, imparts linear motion to lead screw 170, causing piston 165 to actuate.

Similarly, in the example of FIGURE 2, dispense-stage pump 180 ("dispense pump 180") includes a dispense chamber 185, a dispense stage diaphragm 190, a piston 192, a lead screw 195, and a dispense motor 200. Those skilled in the art can appreciate that a variety of pumps may be used in feed stage 105 and dispense stage 110 and that feed pump 150 and dispense pump 180 need not be limited to rolling diaphragm pumps.

Likewise, feed motor 175 and dispense motor 200 can be any suitable motor. As an example, dispense motor 200 can be a Permanent-Magnet Synchronous Motor ("PMSM"). The PMSM can be controlled by a digital signal processor ("DSP") utilizing Field-Oriented Control ("FOC") or other type of speed/position control at dispense motor 200, a controller onboard multi-stage pump 100 or a separate pump controller (e.g., pump controller 20 shown in FIGURE 1). Dispense motor 200 implementing a PMSM can further include an encoder (e.g., a fine line rotary position encoder) for real time feedback of motor position. The use of a position sensor enables accurate and repeatable control of motor position and hence the position of piston 192, which leads to accurate and repeatable control over fluid movements in dispense chamber 185. For, example, using a 2000 line encoder which gives 8000 counts per one motor revolution to the DSP, it is possible to accurately measure to and control at .045 degrees of rotation of the motor. In addition, a PMSM can run at low velocities with little or no vibration, which is desirable in dispense operations. Feed motor 175 can also be a PMSM or a stepper motor.

In operation, multi-stage pump 100 can include a number of segments including, but are not limited to, a ready segment, a dispense segment, a fill segment, a pre-filtration segment, a filtration segment, a vent segment, a purge segment, and a static purge segment. Examples of segments and associated valve and motor timings can be found in WO 2008/066589 A2, entitled "SYSTEM AND METHOD FOR OPERATION OF A PUMP"; U.S. Patent No. 8,025,486, entitled "SYSTEM AND METHOD FOR VALVE SEQUENCING IN A PUMP"; WO 2013/028542 A2, entitled "SYSTEM AND METHOD FOR DETECTING AIR IN A FLUID"; and WO 2012/054706 A2, entitled "METHOD AND SYSTEM FOR PUMP PRIMING".

By way of example, during the fill segment (which may also be referred to as a feed segment), inlet valve 125 is opened and feed stage pump 150 moves (e.g., pulls) feed stage diaphragm 160 to draw fluid into feed chamber 155. Once a sufficient amount of fluid has filled feed chamber 155, inlet valve 125 is closed. During the filtration segment, feed-stage pump 150 moves feed stage diaphragm 160 to displace fluid from feed chamber 155. Isolation valve 130 and barrier valve 135 are opened to allow fluid to flow through filter 120 to dispense chamber 185. Isolation valve 130 can be opened first (e.g., in the "pre-filtration segment") to allow pressure to build in filter 120 and then barrier valve 135 is opened to allow fluid flow into dispense chamber 185. During the filtration segment, dispense pump 180 can be brought to its home position which, in some cases, can be a variable home position.

Examples of a variable home position dispense system can be found in U.S. Patent No. 8,292,598, entitled "SYSTEM AND METHOD FOR A VARIABLE HOME POSITION DISPENSE SYSTEM" and WO 2006/057957 A2, entitled "SYSTEM AND METHOD FOR VARIABLE HOME POSITION DISPENSE SYSTEM". As an example, the home position for dispense stage diaphragm 190 can be selected based on various parameters for a dispense cycle such that dispense chamber 185 at dispense pump 180 contains a sufficient amount of fluid (which can be less than the maximum capacity of dispense chamber 185) to perform the various steps of the dispense cycle while minimizing the hold-up volume in dispense pump 180. Feed pump 150 can similarly be brought to a home position that defines a volume for an amount of fluid that is less than its maximum capacity.

As fluid flows into a chamber in a pump, the pressure of the fluid increases. In the example of FIGURE 2, feed pump 150 includes a pressure sensor 114 coupled to feed chamber 155 for measuring the pressure of fluid at feed stage 105. Likewise, dispense pump 180 includes a pressure sensor 112 coupled to dispense chamber 185 for measuring the pressure of fluid at dispense stage 110. The pressure sensors may be in communication with the control logic (e.g., pump controller 20) described above. The pressures measured by pressure sensor 112 and pressure sensor 114 can be used by the control logic to control the speed of various pumps, perform statistical analyses, and determine whether a dispense was a good one. Examples of suitable pressure sensors (which are also referred to as pressure transducers) may include, but are not limited to, piezoresistive (piezoelectric) and capacitive pressure sensors, including ceramic and polymer pressure sensors manufactured by Metallux AG of Nellmersbach, Germany.

Embodiments can regulate/control fluid pressure at both feed stage 105 and dispense stage 110 based at least in part on measurements received from sensors 112 and 114. For example, when the fluid pressure in dispense chamber 185 reaches a predefined pressure set point (e.g., as measured by pressure sensor 112) during a filtration segment, dispense pump 180 may begin to withdraw dispense stage diaphragm 190. In other words, dispense pump 180 is controlled to increase the available volume of dispense chamber 185 to allow fluid to flow into dispense chamber 185. This can be done, for example, by reversing dispense motor 200 at a predefined rate, causing the pressure in dispense chamber 185 to decrease.

During a dispense, when the fluid pressure in dispense chamber 185 falls below the set point (within the tolerance of the system), the motor rate of feed motor 175 can be increased to cause the pressure in dispense chamber 185 to rise and reach the set point. When the fluid pressure in dispense chamber 185 exceeds the set point (within the tolerance of the system), the motor rate of feed motor 175 can be decreased, leading to a lessening of pressure in downstream dispense chamber 185. The process of increasing and decreasing the speed of feed motor 175 can be repeated until dispense pump 180 reaches a home position, at which point both motors can be stopped.

In the above-referenced WO 2008/066589 A2, entitled "SYSTEM AND METHOD FOR OPERATION OF A PUMP," pressure measurements are taken by a pressure sensor at the dispense side ("dispense pressure"). Embodiments disclosed herein further include a pressure sensor for sensing fluid pressure at the feed (fill) side ("fill pressure"). The ability to detect the fill pressure and changes in the fill pressure at the fill side can be beneficial. For example, it may allow the system to detect a problem or issue before the dispense stage (e.g., air in the fill line or at the filter) and provide an early warning and/or take appropriate action to address or solve the problem or issue at hand.

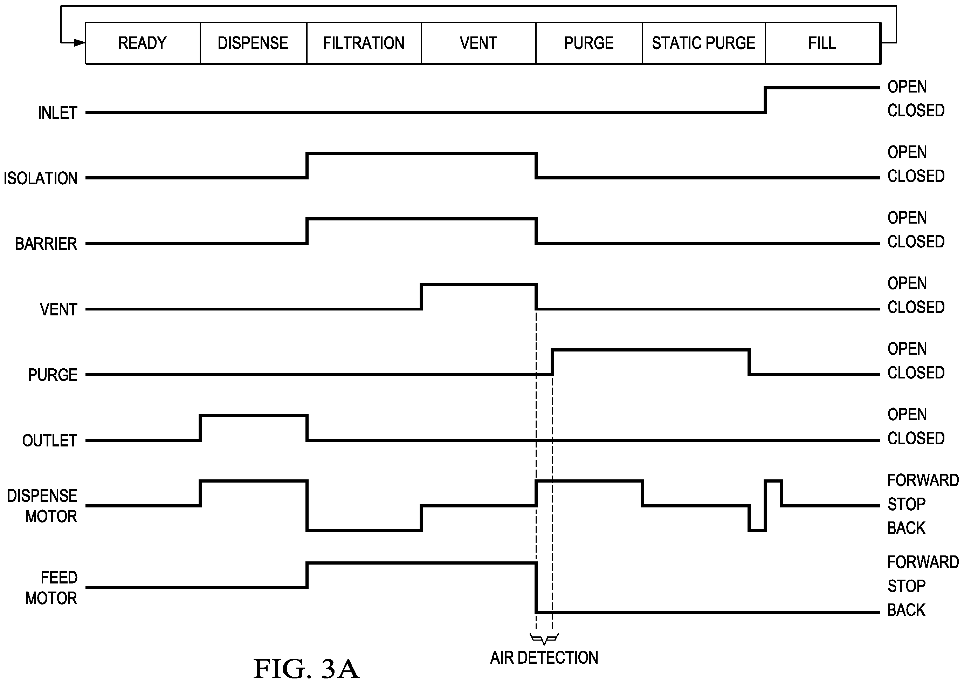

As an example, referring to FIGURE 3A which shows valve and dispense motor timings for various segments of the operation of multi-stage pump 100 of FIGURE 2, at the beginning of a vent segment, isolation valve 130 is opened and vent valve 145 opened. Feed pump 150 is controlled to apply pressure to the fluid to remove air bubbles from filter 120 through open vent valve 145. As shown in FIGURE 3A, barrier valve 135 can remain open during the vent segment and close at the end of the vent segment. If so, the pressure in filter 120 can be detected (e.g., by a controller such as pump controller 20 described above) because the pressure in dispense chamber 185, which can be measured by pressure sensor 112, can be affected by the pressure in filter 120. When barrier valve 135 is closed, the pressure in filter 120 can still be detected because the pressure in feed chamber 155, which can be measured by pressure sensor 114, can be affected by the pressure in filter 120.

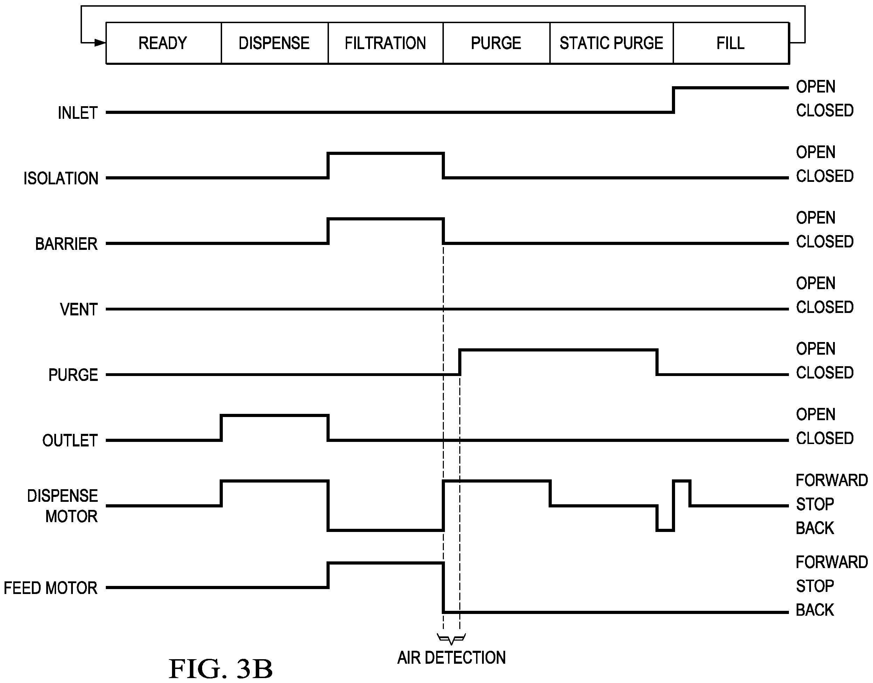

While several valves are shown in FIGURE 3A as closing simultaneously during segment changes, the closing of valves can be timed slightly apart (e.g., 100 milliseconds) to reduce pressure spikes. For example, between the vent segment and the purge segment, isolation valve 130 can be closed shortly before vent valve 145 is opened. It should be noted, however, other valve timings can be utilized in various embodiments. Additionally, several of the segments can be performed together (e.g., the fill/dispense stages can be performed at the same time, in which case, both the inlet and outlet valves can be open in the dispense/fill segment). It should be further noted that specific segments do not have to be repeated for each cycle. For example, the purge and static purge segments may not be performed every cycle. Similarly, the vent segment may not be performed every cycle, as exemplified in FIGURE 3B. Furthermore, any suitable valve and motor timings can be used.

Feed pump 150 can be controlled to cause venting to occur at a predefined rate, allowing for longer vent times and lower vent rates, thereby allowing for accurate control of the amount of vent waste. If feed pump 150 is a pneumatic style pump, a fluid flow restriction can be placed in the vent fluid path, and the pneumatic pressure applied to feed pump 150 (and measured by pressure sensor 114) can be increased or decreased in order to maintain a "venting" set point pressure, providing some control of an otherwise un-controlled method.

As illustrated in FIGURES 3A and 3B, an air detection test may be performed during a segment (e.g., at the start of a purge segment, as explained below). To perform an air detection test, barrier valve 135, purge valve 140, and outlet valve 147 can be closed to isolate dispense chamber 185. Dispense motor 200 is controlled to bring dispense chamber 185 to a desired pressure (e.g., 5 pounds per square inch (psi)). Dispense motor 200 is then moved a fixed distance and the change (delta) in pressure (P) in dispense chamber 185 is determined. By determining the pressure change (delta P) for a fixed change in volume of isolated dispense chamber 185 (or other isolated portion of a pumping system), the amount of air in dispense chamber 185 (or the isolated portion of the pumping system including tubing up to output valve 147 or other valve prior to the nozzle) can be determined, as discussed in the above-referenced WO 2013/028542 A2, entitled "SYSTEM AND METHOD FOR DETECTING AIR IN A FLUID."

In some embodiments, dispense motor 200 can be controlled to maintain a predefined pressure change (e.g., defined by a user via an interface to a pumping system). To achieve the predefined pressure change, a controller may determine an appropriate change in the available volume in dispense chamber 185 and control dispense motor 200 to move piston 192 accordingly. Again, this measure can be used to determine the amount of air in dispense chamber 185 or the isolated portion of the pumping system including tubing up to output valve 147 or other valve prior to the nozzle, as discussed in the above-referenced WO 2013/028542 A2, entitled "SYSTEM AND METHOD FOR DETECTING AIR IN A FLUID." In some cases, if the measure of detected air is less than a threshold amount, a purge and/or static purge segment can be skipped, shortening cycle time. If the amount of detected air is greater than a threshold, a warning or corrective action can be taken.

In some cases, during a purge segment, isolation valve 130 is closed, barrier valve 135 is closed, vent valve 145 is closed, purge valve 140 is open, and outlet valve 147 is closed. As illustrated in FIGURES 3A and 3B, there can be a delay before opening purge valve 140 during which dispense chamber 185 is isolated. Dispense pump 180 can apply pressure to the fluid in dispense chamber 185 so that the air detection test can be performed.

During the purge segment, when purge valve 140 is opened, dispense pump 180 applies pressure to the fluid in dispense chamber 185 to vent air bubbles through purge valve 140. During the static purge segment, dispense pump 180 is stopped, but purge valve 140 remains open to continue to vent air. Any excess fluid removed during the purge or static purge segments can be routed out of multi-stage pump 100 (e.g., returned to fluid source 15, a reservoir tank, or discarded) or recycled to feed stage 105.

As exemplified in FIGURES 3A and 3B, all the valves may be closed during the ready segment. In some cases, isolation valve 130 and barrier valve 135 can be opened and purge valve 140 closed so that feed pump 150 can reach ambient pressure of a fluid source (e.g., a source bottle or reservoir tank).

During the dispense segment, outlet valve 147 opens and dispense pump 180 applies pressure to the fluid in dispense chamber 185. Because outlet valve 147 may react to controls more slowly than dispense pump 180, outlet valve 147 can be opened first and some predetermined period of time later dispense motor 200 started. This prevents dispense pump 180 from pushing fluid through a partially opened outlet valve 147 or pushing into a closed valve for some period of time. Moreover, this prevents fluid moving up the dispense nozzle caused by the valve opening, followed by forward fluid motion caused by motor action. In some cases, outlet valve 147 can be opened and dispense pump 180 may begin to dispense simultaneously.

Other segments may also be performed. For example, a suckback segment can be performed to remove excess fluid in the dispense nozzle. During the suckback segment, outlet valve 147 can close and a secondary motor or vacuum can be used to suck excess fluid out of the outlet nozzle. Alternatively, outlet valve 147 can remain open and dispense motor 200 can be reversed to draw fluid back into dispense chamber 185. The suckback segment can help prevent dripping of excess fluid onto wafer 25.

The opening and closing of various valves can cause pressure spikes in the fluid. Closing of purge valve 140 at the end of the static purge segment, for example, can cause a pressure increase in dispense chamber 185. This can occur because each valve may displace a small volume of fluid when it closes. For instance, purge valve 140 can displace a small volume of fluid into dispense chamber 185 as it closes. Because outlet valve 147 is closed when the pressure increases occur due to the closing of purge valve 140, "spitting" of fluid onto a wafer may occur during the subsequent dispense segment if the pressure is not reduced. To release this pressure during the static purge segment, or an additional segment, dispense motor 200 may be reversed to back out piston 192 a predetermined distance to compensate for any pressure increase caused by the closure of barrier valve 135 and/or purge valve 140.

It should be noted that during the ready segment, the pressure in dispense chamber 185 can change based on the properties of the diaphragm, temperature or other factors. Dispense motor 200 can be controlled to compensate for this pressure drift.

By controlling pump operations at both the fill side and the dispense side based on real-time feedback from pressure sensors at the feed pump and at the dispense pump, embodiments of a multi-stage pump disclosed herein can provide gentle fluid handling and avoid potentially damaging pressure spikes. As discussed above, various pump control mechanisms and valve timings can further help to reduce deleterious effects of pressure on a process fluid. For example, valve and motor timings may be selected to reduce closing valves on an entrapped space.

However, depending upon the type of pumps used, additional technical features may be needed. For example, motor-driven piston assemblies in rolling diaphragm pumps (for single- or multi-stage pumping systems) may suffer backlash, which can reduce the accuracy of the pumps. As discussed above, traditional anti-backlash devices used with pump pistons are coupled to the motor and lead screw and can create a significant force which the motor must overcome to advance a piston. This significant force, and the heat that it generates, can also adversely affect the accuracy of the pumps and potentially damage the process fluid. Thus, anti-backlash devices implemented at the motor side are not feasible or desirable for embodiments of a pumping system disclosed herein and, by extension, not feasible or desirable for a variety of precision systems such as fluid flow or valve control systems where movements of motor-driven pistons need to be precisely controlled.

Embodiments described herein include an anti-backlash mechanism (which is also referred to herein as an anti-backlash device) to reduce or eliminate backlash between a piston and a lead screw. The anti-backlash device requires only minimal additional force to overcome. Accordingly, compared to a traditional anti-backlash device, embodiments of an anti-backlash device described herein can allow a smaller motor to be used to drive the piston to achieve a desired pressure. It is estimated, for example, that for typical pressures used in dispensing process fluids for semiconductor manufacturing (e.g., 5 psi (34473.8 Pa) to 30 psi (206842.8 Pa), and in some cases up to 60 psi (413685.6 Pa)), embodiments of anti-backlash devices discussed herein can allow the motor to be several times smaller (estimated at approximately 3-4 times or 25%-50% smaller) when compared to traditional anti-backlash mechanisms discussed above. The use of a smaller motor both reduces pump footprint and reduces heat generation that can negatively impact sensitive fluids.

An anti-backlash device, in some embodiments, can be external to the piston. In other embodiments, the anti-backlash mechanism can be fully or partially internal to the piston allowing, in some cases, space that otherwise would be wasted to be used to increase the accuracy or repeatability of piston operations.

An anti-backlash device can be used with any suitable arrangement of a lead screw and/or a piston. Anti-backlash devices can be used in multiple-stage or single-stage pumps. In a multiple stage pump, an anti-backlash device can be used at the feed stage, dispense stage, or both.

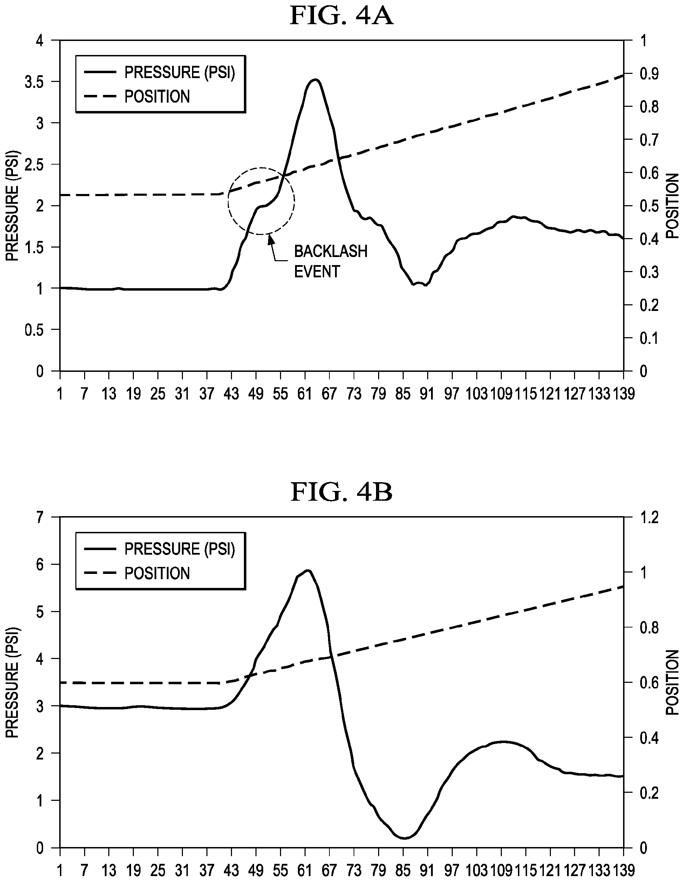

In embodiments disclosed herein, an anti-backlash device can increase the reliability of tests such as air detection and dispense confirmation tests. In particular, one problem that can occur in pumps is that a backlash event may occur at low pressure. This is illustrated in FIGURE 4A.

If a dispense segment or air detection test begins at too low of a pressure, the dispense confirmation or air detection test may be affected by a backlash event, making the test unreliable. For example, if backlash occurs at a dispense chamber ready pressure of less than 2 psi (13789.52 Pa) in a pump, then a dispense confirmation test may be less reliable for pump setup's (e.g., recipes) with a ready pressure of less than 2 psi (13789.52 Pa).

The previous solution to this problem was to set the ready pressure (which is a system setting) to a higher value (e.g., at 3 psi (20684.28 Pa) using the previous example). This is illustrated in FIGURE 4B. Notice in FIGURE 4B, the backlash event shown in FIGURE 4A is eliminated when ready pressure is set at 3 psi (20684.28 Pa).

However, this solution is unsatisfactory for users wishing to use a pump setup with a ready pressure at a lower pressure (e.g., at 1 psi (6894.76 Pa), following the previous example). What is needed, therefore, is an anti-backlash device that can shift the pressure at which a backlash event occurs to a lower pressure (including a negative pressure), allowing users to set lower ready pressures while maintaining the ability to reliably perform the air detection test, dispense confirmation test, or other tests.

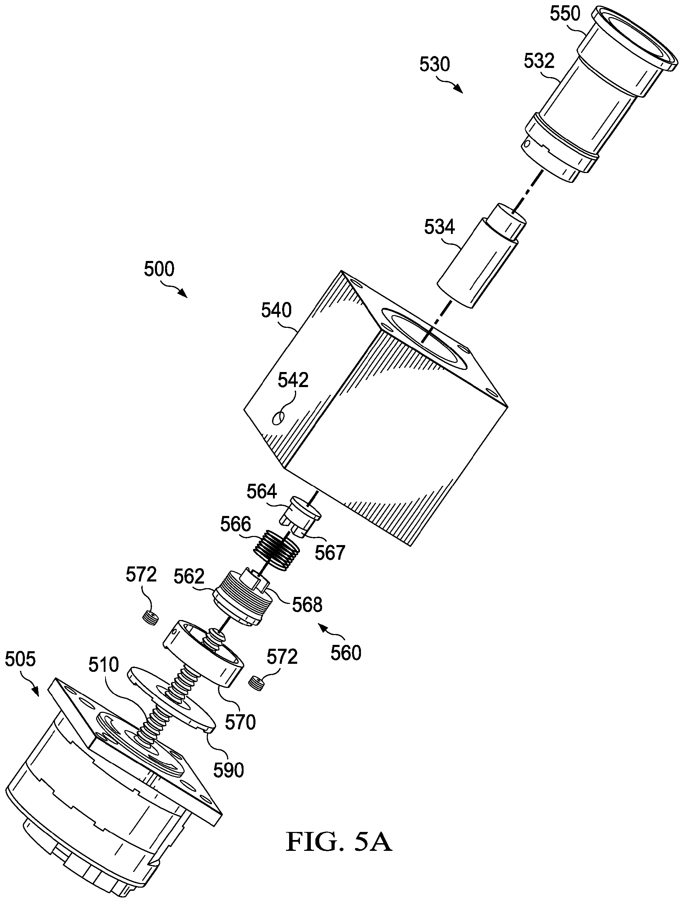

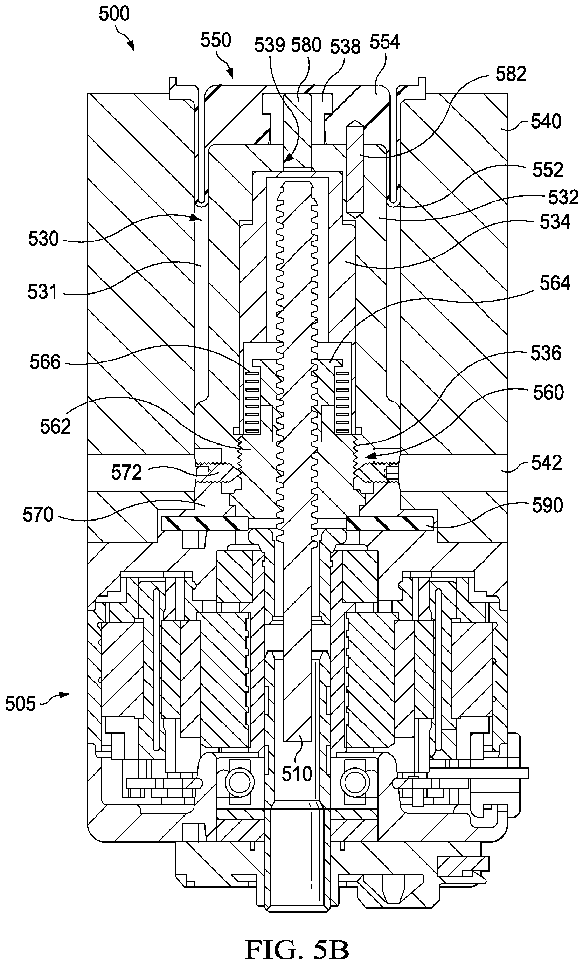

FIGURES 5A and 5B are views of one embodiment of a motor-driven piston assembly 500 having anti-backlash mechanism 560. Assembly 500 comprises a motor 505, a lead screw 510, a piston 530, a housing 540, a diaphragm 550 coupled to piston 530, and an anti-backlash mechanism 560. Piston 530 is operatively coupled to lead screw 510 by anti-backlash mechanism 560. When lead screw 510 turns (i.e., rotated by motor 505), anti-backlash mechanism 560 translates, moving piston 530 in housing 540 to actuate diaphragm 550. According to one embodiment, diaphragm 550 is a rolling diaphragm that has a portion 552 (see FIGURE 5B) that rolls and unrolls in a gap (space) 531 between piston 530 and housing 540.

Rotation of piston 530 and anti-backlash mechanism 560 as lead screw 510 rotates can be reduced or prevented. For example, guides, tracks or other features may be used to prevent or limit rotation of piston 530 relative to housing 540. According to one embodiment, diaphragm 550 may be fixed to housing 540 or other structure (for instance, by having a portion sandwiched between housing 540 and a dispense block as described in the above-referenced WO 2008/066589 A2, entitled "SYSTEM AND METHOD FOR OPERATION OF A PUMP") and piston 530 may be coupled to diaphragm 550 in a manner that prevents or limits rotation of piston 530 relative to diaphragm 550. Furthermore, anti-backlash mechanism 560 may be coupled to piston 530 in a manner that prevents or limits rotation of anti-backlash mechanism 560 relative to piston 530.

Anti-backlash mechanism 560 comprises a first nut 562, a second nut 564, and a spring force biasing member (spring) 566. In some cases, nut 562 or nut 564 may be integrated as part of piston 530. First nut 562 has a set of first nut inner threads or other features (for example, balls in a ball screw arrangement) to engage the threads of lead screw 510 and second nut 564 has a set of second nut inner threads or other features to engage the threads of lead screw 510. First nut 562 and second nut 564 engage the threads of lead screw 510 such that first nut 562 and second nut 564 can translate along lead screw 510 as lead screw 510 rotates. The threads are engaged with lead screw 510 the entire time (when lead screw 510 is rotated by motor 505) and ready to move - as soon as motor 505 moves, lead screw 510 moves, and piston 530 moves. There is no lag and hence no backlash.

First nut 562 and second nut 564 may be maintained in a spaced relationship along lead screw 510 such that there is a gap in the axial direction between facing surfaces of first nut 562 and second nut 564. According to one embodiment, second nut 564 may be able to translate slightly along lead screw 510 relative to first nut 562 such that the size of the gap between first nut 562 and second nut 564 can change (as constrained by, for instance, spring 566). In some embodiments, the size of the gap between first nut 562 and second nut 564 can be limited by spring force, friction, physical stops, etc. Relative rotation between first nut 562 and second nut 564 can be limited or prevented by rotation locking features (for example, one or more indents, recesses, depressions 568 and one or more detents, catches, protrusions 567) or other complementary locking features.

Spring 566 can comprise a compression spring or other spring force biasing member that can bias (push or pull) first nut 562 and second nut 564 together or apart by spring force. Spring force (F) refers to the force exerted by a spring and is a function of the displacement or distance the spring is compressed or pulled/extended (d) and the spring constant (k), which depends on the material and shape of the spring, such that F = kd. In some embodiments, spring 566 can be a compression spring that biases first nut 562 and second nut 564 apart. In the arrangement illustrated, lead screw 510 passes through first nut 562, compression spring 566, and second nut 564. In this example, spring 566 abuts first nut 562 and second nut 564 and biases them apart.

That is, spring 566 pushes first nut 562 in an axial direction toward motor 505 so that first nut 562 remains engaged with lead screw 510 when lead screw 510 is rotated by motor 505. The spring constant k of spring 566 can be selected such that spring 566 provides enough force (e.g., sufficient to mimic a 3 psi downward force) to ensure first nut 562 always engages with lead screw 510, but not too much to create load on motor 505. A person of ordinary skill in the art can calibrate the necessary spring force based on motor strength, load applications, pressure, etc. to keep first nut 562 engaged with lead screw 510 and not too much as to negatively affect the power of motor 505, taking into consideration of heat that may be generated relative to an increase in motor power.

Thus, it can be appreciated that spring 566 can bias first nut 562 and second nut 564 so that the inner threads or other features of first nut 562 maintain engagement with a first face of the lead screw threads, reducing or eliminating slack (backlash) for a first direction of lead screw rotation. In some cases, inner threads or other features of second nut 564 may maintain engagement with a second face of the lead screw threads so that slack is eliminated or reduced for a second direction of lead screw rotation.

In some embodiments, the inner threads or other features of first nut 562 may maintain engagement with the advancing face of the lead screw threads so that slack is eliminated or reduced between first nut 562 and the advancing thread face of the lead screw when lead screw 510 changes directions from retracting piston 530 to advancing piston 530. The inner threads or other features of second nut 564 may maintain engagement with the retracting face of the lead screw threads so that slack is eliminated or reduced between second nut 564 and the retracting thread face of the lead screw when lead screw 510 changes directions from advancing piston 530 to retracting piston 530.

Anti-backlash mechanism 560 can be coupled to piston 530 such that translation of anti-backlash mechanism 560 causes translation of piston 530. In some cases, anti-backlash mechanism 560 may be arranged so that at least a portion to all of anti-backlash mechanism 560 is contained within piston 530. In other arrangements, anti-backlash mechanism 560 can be coupled to, but not contained in piston 530.

First nut 562 (or second nut 564) can be coupled to piston 530 so that translation of first nut 562 (or second nut 564) causes translation of piston 530. According to one embodiment, first nut 562 can be in fixed relation to piston 530. In the embodiment illustrated, for example, first nut 562 includes outer threads and piston 530 includes inner threads 536 (as shown in FIGURE 5B) such that first nut 562 can screw into piston 530. A counter rotation mechanism can prevent first nut 562 from backing out of piston 530. As one example, set screws 572 pass through openings in the sides of piston 530 and contact first nut 562 to prevent rotation of first nut 562 relative to piston 530. Ring 570 may also prevent first nut 562 from backing out.

According to one embodiment, piston 530 comprises an inner cavity that houses all or a substantial portion of anti-backlash mechanism 560. The inner cavity may include an opening at an end distal from diaphragm 550 with threads 536 or other features disposed proximate to the opening to receive first nut 562. The inner cavity may also accommodate lead screw 510. Piston 530 may also include side openings to receive set screws 572 or include other features to prevent counter rotation or backing out of first nut 562.

Piston 530 may include features to couple to diaphragm 550. Piston 530 may include resilient fingers 538 projecting from the end of piston 530 proximate to diaphragm 550. Fingers 538 may be disposed about a pin opening 539 through that end. Resilient fingers 538 can collapse together slightly or fully at their ends such that they can be inserted in an opening in base 554 of diaphragm 550. A pin 580 inserted through pin opening 539 can force resilient fingers 538 apart so that features of resilient fingers 538 (such as shoulders) engage with features of diaphragm 550 (such as shoulders) to capture resilient fingers 538.

Piston 530 may also include features to limit or prevent rotation of piston 530 relative to diaphragm 550. In one embodiment, one or more pins 582 are received in aligned openings in the end of piston 530 and base 554 of diaphragm 550. Such pins or other features can inhibit rotation of piston 530 relative to diaphragm 550 when lead screw 510 rotates.

Piston 530 can be a single piece or may comprise multiple components. In one embodiment, piston 530 comprises an outer portion 532 that defines the piston inner cavity and an inner portion 534 that defines an inner portion cavity open to an end of inner portion 534. In some cases, all or a portion of anti-backlash mechanism 560 can be received in the inner portion cavity. Inner portion 534 can seat inside outer portion 532. According to one embodiment, inner portion 534 can abut the inner side of the end of outer portion 532 proximate to diaphragm 550 to trap pin 580 in opening 539. It can thus be appreciated that inner portion 534 can provide one embodiment of a piston pin retainer.

Outer portion 532 can comprise threads 536 or other features disposed proximate to the opening to receive first nut 562. Outer portion 532 may also include side openings to receive set screws 572 or include other features to prevent counter rotation or backing out of first nut 562.

Assembly 500 can further include retaining ring 570. According to one embodiment, the center opening through ring 570 may have a portion of sufficient diameter and length so that a portion of ring 570 can fit over an end of piston 530. According to one embodiment, ring 570 can be configured so that set screw openings through ring 570 align with set screw opening through the sides of piston 530. The openings may also align with openings 542 through housing 540. The set screw openings through ring 570 can be threaded. The center opening of ring 570 may further comprise a portion that is narrower in diameter so that a portion of ring 570 overlaps first nut 562 in a manner that further prevents backing out of first nut 562. For example, first nut 562 may abut shoulders on retaining ring 570, preventing first nut 562 from backing out.

Assembly 500 can further include spacer 590. According to one embodiment, spacer 590 can be used to prevent portions of piston 530 or anti-backlash mechanism 560 from contacting motor 505.

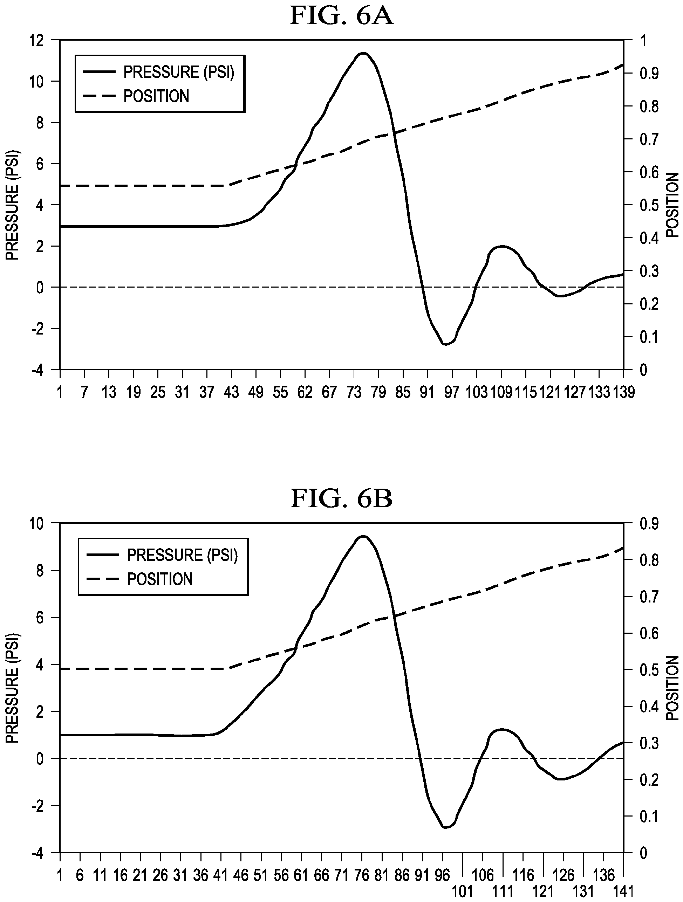

FIGURES 6A and 6B are plot diagrams exemplifying how an anti-backlash mechanism disclosed herein can eliminate backlash regardless of ready pressure settings. Specifically, FIGURE 6A shows an example in which the ready pressure is set at 3 psi for a pumping system having an embodiment of anti-backlash mechanism disclosed herein. At 3 psi, there is no backlash event. FIGURE 6B shows an example in which the ready pressure is set at less than 3 psi. As illustrated in FIGURE 4A, without an embodiment of an anti-backlash mechanism disclosed herein, a backlash event may occur when the ready pressure is at less than 3 psi. As illustrated in FIGURE 6B, with an embodiment of an anti-backlash mechanism disclosed herein, there is no backlash event in the pumping system even when the ready pressure is set at less than 3 psi.

While discussed primarily in terms of a piston in a pumping system, the anti-backlash mechanism disclosed herein can be integrated or used with other translating portions of an assembly that translate along a lead screw. For example, in some embodiments, an anti-backlash system for coupling to a lead screw can comprise a translating portion and an anti-backlash mechanism coupled to the translating portion for operatively coupling the translating portion to the lead screw. The anti-backlash mechanism can comprise a first nut that engages the lead screw threads, a second nut that engages the lead screw threads and a biasing member such as a compression spring. Such an anti-backlash system can include one or more of the following aspects along with others:
- One of the first nut or second nut may be in fixed relation to the translating portion.
- The biasing member may bias the first nut and second nut apart.
- The biasing member may bias the translating portion toward a motor.
- The biasing member may bias the first nut so that the first nut remains engaged with a first face of the lead screw threads.
- The biasing member may bias the first nut so that the first nut remains engaged with an advancing face of the lead screw threads.
- The biasing member may comprise a compression spring.
- The biasing member, first nut and second nut may be axially aligned.
- The lead screw may pass through the first nut, second nut and biasing member.
- The first nut and second nut may be spaced along the lead screw.
- The anti-backlash mechanism may be spaced along a lead screw a distance away from a motor.
- The first nut may be located more proximate to the motor than the second nut.
- The first nut and second nut may comprise features to limit rotation of the second nut relative to the first nut.
- The first nut may be in fixed relation to the translating portion.
- The first nut may include threads that mate with inner threads of the translating portion.
- The anti-backlash mechanism may be partially or fully contained in the translating portion.
- The nut in fixed relation to the translating portion may be integrated with the translating portion.
- An anti-rotation mechanism can be used to prevent rotation of the anti-backlash mechanism relative to the translating portion.
- The anti-rotation mechanism may comprise a retaining ring.
- The anti-rotation mechanism may comprise features to prevent counter rotation of the first nut or second nut.
- The translating portion may comprise a piston.
- The piston may comprise a piston inner cavity.
- All or a portion of the anti-backlash mechanism may be housed in the piston inner cavity.
- The piston may comprise an inner portion and an outer portion.
- The inner portion may act as a pin retaining portion.
- The piston may comprise a set of resilient fingers extending from an end of the piston.
- The set of resilient fingers may be disposed about an opening.
- A pin may be disposed in the pin opening and may push the resilient fingers radially outward to engage a diaphragm.
- A counter rotation mechanism may prevent rotation of the piston relative to the diaphragm.
- One or more pins or other features may project from an end face of the piston and be received by the diaphragm to prevent rotation of the piston relative to the diaphragm.
- The anti-backlash system may further comprise a diaphragm.
- The diaphragm may be a rolling diaphragm that rolls and unrolls in a gap between the piston and a housing.
- The diaphragm may comprise a base that receives one or more features to couple the diaphragm to the piston, such as openings to receive pins or resilient fingers or other features.

According to one embodiment, a system, such as pump, or other system, can comprise a motor, a lead screw and an anti-backlash system (e.g., as described above). For example, in a multi-stage pump, one or more anti-backlash systems may be used at a single stage or at multiple stages. Additional examples of pumps, routines, management systems, etc. can be found in the above-referenced WO 2008/066589 A2, entitled "SYSTEM AND METHOD FOR OPERATION OF A PUMP"; U.S. Patent No. 8,025,486, entitled "SYSTEM AND METHOD FOR VALVE SEQUENCING IN A PUMP"; WO 2013/028542 A2, entitled "SYSTEM AND METHOD FOR DETECTING AIR IN A FLUID"; and WO 2012/054706 A2, entitled "METHOD AND SYSTEM FOR PUMP PRIMING."

As will be appreciated, some routines, methods, steps, operations or portions thereof described herein can be implemented through control logic, including computer executable instructions stored on a computer readable medium, hardware, firmware or a combination thereof. The control logic can be adapted to direct an information processing device to perform a set of steps disclosed in the various embodiments. Some embodiments may be implemented by using software programming or code in one or more digital computers, by using application specific integrated circuits, programmable logic devices, field programmable gate arrays, optical, chemical, biological, quantum or nanoengineered systems, components and mechanisms. Based on the disclosure and teachings provided herein, a person of ordinary skill in the art will appreciate other ways and/or methods to implement the invention.

Any particular step, operation, method, routine, operation or portion thereof can execute on a single computer processing device or multiple computer processing devices, a single computer processor or multiple computer processors. Data may be stored in a single storage medium or distributed through multiple storage mediums, and may reside in a single database or multiple databases (or other data storage). The sequence of operations described herein can be interrupted, suspended, or otherwise controlled by another process, such as an operating system, kernel, etc. The routines can operate in an operating system environment or as stand-alone routines.

Embodiments of routines, methods, steps, operations or portions thereof can be implemented in one or more computer communicatively coupled to a network (for example, the Internet, an intranet, an internet, a WAN, a LAN, a SAN, etc.), another computer, or in a standalone computer. As is known to those skilled in the art, the computer can include a CPU or processor, memory (e.g., primary or secondary memory such as RAM, ROM, HD or other computer readable medium for the persistent or temporary storage of instructions and data) and one or more I/O device(s). The I/O devices can include a keyboard, monitor, printer, electronic pointing device (for example, mouse, trackball, stylus, etc.), touch screen or the like. In embodiments, the computer has access to at least one database on the same hardware or over the network.

As used herein, the terms "comprises," "comprising," "includes," "including," "has," "having" or any other variation thereof, are intended to cover a non-exclusive inclusion. For example, a process, article, or apparatus that comprises a list of elements is not necessarily limited to only those elements but may include other elements not expressly listed or inherent to such process, article, or apparatus.

Further, unless expressly stated to the contrary, "or" refers to an inclusive or and not to an exclusive or. That is, the term "or" as used herein is generally intended to mean "and/or" unless otherwise indicated. For example, a condition A or B is satisfied by any one of the following: A is true (or present) and B is false (or not present), A is false (or not present) and B is true (or present), and both A and B are true (or present).

As used herein, a term preceded by "a" or "an" (and "the" when antecedent basis is "a" or "an") includes both singular and plural of such term unless the context clearly dictates otherwise. Also, as used in the description herein, the meaning of "in" includes "in" and "on" unless the context clearly dictates otherwise.

Additionally, any examples or illustrations given herein are not to be regarded in any way as restrictions on, limits to, or express definitions of, any term or terms with which they are utilized. Instead, these examples or illustrations are to be regarded as being described with respect to one particular embodiment and as illustrative only. Those of ordinary skill in the art will appreciate that any term or terms with which these examples or illustrations are utilized will encompass other embodiments which may or may not be given therewith or elsewhere in the specification and all such embodiments are intended to be included within the scope of that term or terms. Language designating such non-limiting examples and illustrations includes, but is not limited to: "for example," "for instance," "e.g.," "in one embodiment."

Reference throughout this specification to "one embodiment," "an embodiment," or "a specific embodiment" or similar terminology means that a particular feature, structure, or characteristic described in connection with the embodiment is included in at least one embodiment and may not necessarily be present in all embodiments. Thus, respective appearances of the phrases "in one embodiment," "in an embodiment," or "in a specific embodiment" or similar terminology in various places throughout this specification are not necessarily referring to the same embodiment. Furthermore, the particular features, structures, or characteristics of any particular embodiment may be combined in any suitable manner with one or more other embodiments. It is to be understood that other variations and modifications of the embodiments described and illustrated herein are possible in light of the teachings herein and are to be considered as part of the spirit and scope of the invention.

In the description herein, numerous specific details are provided, such as examples of components and/or methods, to provide a thorough understanding of embodiments of the invention. One skilled in the relevant art will recognize, however, that an embodiment may be able to be practiced without one or more of the specific details, or with other apparatus, systems, assemblies, methods, components, materials, parts, and/or the like. In other instances, well-known structures, components, systems, materials, or operations are not specifically shown or described in detail to avoid obscuring aspects of embodiments of the invention. While the invention may be illustrated by using a particular embodiment, this is not and does not limit the invention to any particular embodiment and a person of ordinary skill in the art will recognize that additional embodiments are readily understandable and are a part of this invention, which is defined by the subject-matter of the appended patent claims.

Although the steps, operations, or computations may be presented in a specific order, this order may be changed in different embodiments. In some embodiments, to the extent multiple steps are shown as sequential in this specification, some combination of such steps in alternative embodiments may be performed at the same time. The sequence of operations described herein can be interrupted, suspended, or otherwise controlled by another process.

## Claims

1. A piston assembly (500), comprising:
a piston (530); and
an anti-backlash device (560);
wherein the piston (530) comprises:
a diaphragm (550); and
a cavity for housing all or a substantial portion of the anti-backlash device (560);
and
wherein the anti-backlash device (560) comprises:
a first nut (562) having a first engagement feature and a first rotation locking feature (568), the first engagement feature structured for engagement with a lead screw (510) of a motor (505), wherein the piston (530) is coupled to the motor (505), and wherein the first nut (562) is coupled to the piston (530) and is fixed in relation to the piston (530);
a second nut (564) having a second engagement feature and a second rotation locking feature (567), the second engagement feature (562) structured for engagement with the lead screw (510), the second rotation locking feature (567) structured to complement the first rotation locking feature (568) for limiting or preventing relative rotation between the first nut (562) and the second nut (564); and
a biasing member (566) for maintaining a spaced relationship between the first nut (562) and the second nut (564) along the lead screw (510) such that the first engagement feature of the first nut (562) remains in engagement with the lead screw (510) to thereby reduce or eliminate backlash when the lead screw (510) is rotated by the motor (505) in a first direction,
the piston further comprising side opening for receiving set screws to prevent counter rotation or to prevent the first nut from backing out.

2. The piston assembly (500) of claim 1, wherein the piston (530) further comprises an opening at an end distal from the diaphragm (550) for receiving the first nut (562).

3. The piston assembly (500) of claim 1, wherein the piston (530) further comprises resilient fingers (538) projecting from an end of the piston (530) proximate to the diaphragm (550), wherein the resilient fingers (538) of the piston (530) are collapsible for insertion into an opening in a base of the diaphragm (550).

4. The piston assembly of claim 1, wherein the second engagement feature of the second nut (564) remains in engagement with the lead screw (510) to thereby reduce or eliminate backlash when the lead screw (510) is rotated by the motor in a second direction.

5. The piston assembly (500) of claim 1, wherein the first engagement feature of the first nut (562) or the second engagement feature of the second nut (564) comprises inner threads.

6. The piston assembly (500) of claim 1, wherein the first engagement feature of the first nut (562) or the second engagement feature of the second nut (564) comprises balls.

7. The piston assembly (500) of claim 1, further comprising a ring (570) to prevent first nut (562) from backing out.

8. A pumping system (10), comprising:
a dispense pump (180) having:
a dispense chamber (185);
a motor (175);
a lead screw (170) coupled to the motor (175); and
a piston assembly (500) according to claim 1, wherein the piston (530) is coupled to the lead screw (170).

9. The pumping system (10) of claim 8, wherein the anti-backlash device (560) is spaced along the lead screw (170) a distance away from the motor (175).

10. The pumping system (10) of claim 8, wherein the first nut (562) is located more proximate to the motor (175) than the second nut (564).

11. The pumping system (10) of claim 8, wherein the first nut (562), the second nut (564), and the biasing member (566) are axially aligned along and pass through the lead screw (175).

12. The pumping system (10) of claim 8, wherein the second engagement feature of the second nut (564) remains in engagement with the lead screw (170) to thereby reduce or eliminate backlash when the lead screw (170) is rotated by the motor (175) in a second direction.

## Patentansprüche

1. Kolbenanordnung (500), umfassend:
einen Kolben (530) und
eine Anti-Spiel-Einrichtung (560),
wobei der Kolben (530) umfasst:
eine Membran (550) und
einen Hohlraum zum Aufnehmen der gesamten oder eines wesentlichen Teils der Anti-Spiel-Einrichtung (560),
und
wobei die Anti-Spiel-Einrichtung (560) umfasst:
eine erste Mutter (562) mit einem ersten Eingriffsmerkmal und einem ersten Drehsicherungsmerkmal (568), wobei das erste Eingriffsmerkmal für einen Eingriff mit einer Gewindespindel (510) eines Motors (505) ausgebildet ist, wobei der Kolben (530) an den Motor (505) gekoppelt ist und wobei die erste Mutter (562) an den Kolben (530) gekoppelt ist und in Bezug auf den Kolben (530) fixiert ist,
eine zweite Mutter (564) mit einem zweiten Eingriffsmerkmal und einem zweiten Drehsicherungsmerkmal (567), wobei das zweite Eingriffsmerkmal (562) für einen Eingriff mit der Gewindespindel (510) ausgebildet ist, wobei das zweite Drehsicherungsmerkmal (567) zum Begrenzen oder Verhindern von Relativdrehung zwischen der ersten Mutter (562) und der zweiten Mutter (564) komplementär zu dem ersten Drehsicherungsmerkmal (568) ausgebildet ist, und
ein Vorspannelement (566) zum Aufrechterhalten einer Beabstandung zwischen der ersten Mutter (562) und der zweiten Mutter (564) entlang der Gewindespindel (510) derart, dass das erste Eingriffsmerkmal der ersten Mutter (562) mit der Gewindespindel (510) in Eingriff bleibt, um hierdurch Spiel zu verringern oder zu beseitigen, wenn die Gewindespindel (510) von dem Motor (505) in einer ersten Richtung gedreht wird,
wobei der Kolben ferner eine Seitenöffnung zum Aufnehmen von Stellschrauben umfasst, um Gegendrehung zu verhindern oder um ein Herausdrehen der ersten Mutter zu verhindern.

2. Kolbenanordnung (500) nach Anspruch 1, wobei der Kolben (530) ferner an einem von der Membran (550) entfernt gelegenen Ende eine Öffnung zum Aufnehmen der ersten Mutter (562) umfasst.

3. Kolbenanordnung (500) nach Anspruch 1, wobei der Kolben (530) ferner elastische Finger (538) umfasst, die von einem nahe der Membran (550) gelegenen Ende des Kolbens (530) hervorstehen, wobei die elastischen Finger (538) des Kolbens (530) für ein Einführen in eine Öffnung in einer Basis der Membran (550) zusammendrückbar sind.

4. Kolbenanordnung nach Anspruch 1, wobei das zweite Eingriffsmerkmal der zweiten Mutter (564) mit der Gewindespindel (510) in Eingriff bleibt, um hierdurch Spiel zu verringern oder zu beseitigen, wenn die Gewindespindel (510) von dem Motor in einer zweiten Richtung gedreht wird.

5. Kolbenanordnung (500) nach Anspruch 1, wobei das erste Eingriffsmerkmal der ersten Mutter (562) oder das zweite Eingriffsmerkmal der zweiten Mutter (564) Innengewinde umfasst.

6. Kolbenanordnung (500) nach Anspruch 1, wobei das erste Eingriffsmerkmal der ersten Mutter (562) oder das zweite Eingriffsmerkmal der zweiten Mutter (564) Kugeln umfasst.

7. Kolbenanordnung (500) nach Anspruch 1, ferner umfassend einen Ring (570), um ein Herausdrehen der ersten Mutter (562) zu verhindern.

8. Pumpsystem (10), umfassend:
eine Abgabepumpe (180) mit:
einer Abgabekammer (185),
einem Motor (175),
einer an den Motor (175) gekoppelten Gewindespindel (170) und
einer Kolbenanordnung (500) nach Anspruch 1, wobei der Kolben (530) an die Gewindespindel (170) gekoppelt ist.

9. Pumpsystem (10) nach Anspruch 8, wobei die Anti-Spiel-Einrichtung (560) entlang der Gewindespindel (170) um eine Entfernung zu dem Motor (175) beabstandet ist.

10. Pumpsystem (10) nach Anspruch 8, wobei sich die erste Mutter (562) näher an dem Motor (175) als die zweite Mutter (564) befindet.

11. Pumpsystem (10) nach Anspruch 8, wobei die erste Mutter (562), die zweite Mutter (564) und das Vorspannelement (566) axial entlang der Gewindespindel (175) ausgerichtet sind und diese durchlaufen.

12. Pumpsystem (10) nach Anspruch 8, wobei das zweite Eingriffselement der zweiten Mutter (564) mit der Gewindespindel (170) in Eingriff bleibt, um hierdurch Spiel zu verringern oder zu beseitigen, wenn die Gewindespindel (170) von dem Motor (175) in einer zweiten Richtung gedreht wird.

## Revendications

1. Ensemble piston (500), comprenant :
un piston (530) ; et
un dispositif antijeu (560) ;
dans lequel le piston (530) comprend :
un diaphragme (550) ; et
une cavité pour contenir la totalité ou une partie substantielle du dispositif antij eu (560) ; et
dans lequel le dispositif antijeu (560) comprend :
un premier écrou (562) ayant un premier moyen d'engagement et un premier moyen de blocage de rotation (568), le premier moyen d'engagement étant structuré pour s'engager avec une vis mère (510) d'un moteur (505), le piston (530) étant couplé au moteur (505), et le premier écrou (562) étant couplé au piston (530) et fixe par rapport au piston (530) ;
un deuxième écrou (564) ayant un deuxième moyen d'engagement et un deuxième moyen de blocage de rotation (567), le deuxième moyen d'engagement (562) étant structuré pour s'engager avec la vis mère (510), le deuxième moyen de blocage de rotation (567) étant structuré pour s'allier avec le premier moyen de blocage de rotation (568) pour limiter ou empêcher la rotation relative entre le premier écrou (562) et le deuxième écrou (564) ; et
un élément de rappel (566) pour maintenir une relation espacée entre le premier écrou (562) et le deuxième écrou (564) le long de la vis mère (510) de telle sorte que le premier moyen d'engagement du premier écrou (562) reste engagé avec la vis mère (510) pour réduire ou éliminer ainsi le jeu lorsque la vis mère (510) est tournée par le moteur (505) dans une première direction,
le piston comprenant en outre une ouverture latérale pour recevoir des vis de blocage pour empêcher la contre-rotation ou pour empêcher le premier écrou de se dévisser.

2. Ensemble piston (500) selon la revendication 1, dans lequel le piston (530) comprend en outre une ouverture à une extrémité distale par rapport au diaphragme (550) pour recevoir le premier écrou (562).

3. Ensemble piston (500) selon la revendication 1, dans lequel le piston (530) comprend en outre des doigts élastiques (538) dépassant d'une extrémité du piston (530) proche du diaphragme (550), dans lequel les doigts élastiques (538) du piston (530) sont déformables pour permettre l'insertion dans une ouverture située dans une base du diaphragme (550).

4. Ensemble piston selon la revendication 1, dans lequel le deuxième moyen d'engagement du deuxième écrou (564) reste engagé avec la vis-mère (510) pour réduire ou éliminer ainsi le jeu lorsque la vis-mère (510) est tournée par le moteur dans une deuxième direction.

5. Ensemble piston (500) selon la revendication 1, dans lequel le premier moyen d'engagement du premier écrou (562) ou le deuxième moyen d'engagement du deuxième écrou (564) comprend un filetage intérieur.

6. Ensemble piston (500) selon la revendication 1, dans lequel le premier moyen d'engagement du premier écrou (562) ou le deuxième moyen d'engagement du deuxième écrou (564) comprend des billes.

7. Ensemble piston (500) selon la revendication 1, comprenant en outre une bague (570) pour empêcher le premier écrou (562) de se dévisser.

8. Système de pompage (10), comprenant :
une pompe de distribution (180) ayant :
une chambre de distribution (185) ;
un moteur (175) ;
une vis-mère (170) couplée au moteur (175) ; et
un ensemble piston (500) selon la revendication 1, dans lequel le piston (530) est couplé à la vis-mère (170).

9. Système de pompage (10) selon la revendication 8, dans lequel le dispositif antijeu (560) est espacé du moteur (175) d'une certaine distance le long de la vis-mère (170).

10. Système de pompage (10) selon la revendication 8, dans lequel le premier écrou (562) est situé plus près du moteur (175) que le deuxième écrou (564).

11. Système de pompage (10) selon la revendication 8, dans lequel le premier écrou (562), le deuxième écrou (564), et l'élément de rappel (566) sont alignés axialement le long de la vis-mère (175) et passent au travers de celle-ci.

12. Système de pompage (10) selon la revendication 8, dans lequel le deuxième moyen d'engagement du deuxième écrou (564) reste engagé avec la vis-mère (170) pour réduire ou éliminer ainsi le jeu lorsque la vis-mère (170) est tournée par le moteur (175) dans une deuxième direction.
